# EUROPÄISCHE PATENTANMELDUNG

(11) **EP 2 637 304 A1**
(43) Veröffentlichungstag der Anmeldung: **11.09.2013**
(21) Anmeldenummer: 12158020.3
(22) Anmeldetag: 05.03.2012
(51) Int. Cl.: H03K 5/003, H03K 17/60

(54) **Digitaleingabeeinheit**

(71) Anmelder: Siemens Aktiengesellschaft, 80333 München (DE)
(72) Erfinder: Maier, Willi, 77728 Oppenau (DE)

(57) **Zusammenfassung**

Die Erfindung betrifft eine Digitaleingabeeinheit für ein Automatisierungsgerät mit mindestens einem Strom (I) ziehenden DC-Eingangskanal zum Anschluss eines an einer DC-Nennspannung betriebenen Gebers (3), wobei der Eingangskanal dazu ausgebildet ist, gemäß einer Eingangskennlinie den Strom (I) in Abhängigkeit der Eingangsspannung (U_{EM}) einzustellen. Es werden Maßnahmen vorgeschlagen, wodurch die Digitaleingabeeinheit zum Anschluss von Gebern unterschiedlicher Versorgungsspannungen geeignet ist, wobei die Digitaleingabeeinheit mit einer verminderten Verlustleistung betrieben werden kann.

## Beschreibung

Die Erfindung betrifft eine Digitaleingabeeinheit für ein Automatisierungsgerät mit mindestens einem Strom ziehenden DC-Eingangskanal zum Anschluss eines an einer DC-Nennspannung betriebenen Gebers, wobei der Eingangskanal dazu ausgebildet ist, gemäß einer Eingangskennlinie den Strom in Abhängigkeit der Eingangsspannung einzustellen.

Eine derartige Digitaleingabeeinheit ist aus dem Siemens-Gerätehandbuch "SIMATIC, S7-300, Automatisierungssystem S7-300, Baugruppendaten", Kapitel 3, Ausgabe 08/2009 bekannt. An einen der Eingangskanäle ist ein Geber anschließbar, z. B. ein Geber in Form eines Bero-Nährungsschalters, der für eine DC-Nennspannung von 24 oder 48 V ausgelegt ist, wobei eine Eingangskennlinie eine so genannte Typ 1- oder Typ 2-Charakteristik gemäß der Norm IEC 61131 bzw. EN 61131 erfüllt.

Diese Norm schreibt für die Typ 1- und Typ 2-Charakteristiken Strom- und Spannungsgrenzen für 0- und 1-Signalzustände vor, wobei die Stromgrenzen gemäß der Typ 2-Charakteristik höher als gemäß der Typ 1-Charakteristik vorgegeben sind. Gemäß der Typ 1-Charakteristik liegt die obere Stromgrenze für einen 0- oder 1-Signalzustand bei 15 mA, gemäß der Typ 2-Charakteristik dagegen bei 30 mA. Mit anderen Worten: Eine Digitaleingabeeinheit nach Typ 2 weist eine im Vergleich zu einer Digitaleingabeeinheit nach Typ 1 stromintensivere Charakteristik auf.

Es kann nun vorkommen, dass aufgrund einer Kundenanforderung eine Digitaleingabeeinheit Funktionen für eine Vielzahl von Gebern unterschiedlicher DC-Nennspannungen erfüllen muss. Die Digitaleingabeeinheit muss in diesem Fall für eine Vielzahl von DC-Eingangsspannungen, z. B. in einem Bereich von 24 V bis 125 V, ausgelegt sein. Ein derartiger "Weitbereichseingang" von 24 V bis 125 V führt bei DC-Eingangsspannungen größer als die genannte 30 V-Spannung im Hinblick auf den 1-Signalzustand aufgrund der stromintensiven Typ 2-Charakteris-tik bezüglich dieses 1-Signalzustandes zu einer hohen Verlustleistung und Wärmebelastung, was sich nachteilig auf die Lebensdauer der Digitaleingabeeinheit auswirkt.

Der Erfindung liegt daher die Aufgabe zugrunde, eine Digitaleingabeeinheit der eingangs genannten Art zu schaffen, welche zum Anschluss von Gebern unterschiedlicher Versorgungsspannungen geeignet ist und welche mit einer verminderten Verlustleistung betrieben werden kann.

Diese Aufgabe wird dadurch gelöst, dass der Eingangskanal dazu ausgebildet ist,
- bis zu einer Umschaltspannung den Eingangsstrom auf einen ersten Wert zu begrenzen, wobei die Umschaltspannung gleich oder größer einer Spannungsgrenze ist, bis zu welcher ein 1-Signalzustand repräsentiert wird, und
- ab dieser Umschaltspannung den Eingangsstrom auf einen im Vergleich zum ersten Wert geringeren zweiten Wert zu begrenzen.

Die Erfindung geht von der Idee aus, die Eingangskennlinie, welche die Abhängigkeit des Stroms von der Eingangsspannung repräsentiert, in Abhängigkeit der Eingangsspannung einzustellen. Dadurch wird die Eingangskennlinie derart optimiert, dass einerseits bei kleinen Eingangsspannungen bis zu einer Umschaltspannungsgrenze bzw. einer Umschaltspannung die Vorteile der Typ 2-Charakteristik erzielt und andererseits bei großen Eingangsspannungen oberhalb dieser Umschaltspannungsgrenze die Nachteile dieser Typ 2-Charakteristik im Hinblick auf die Verlustleistung vermieden werden. Dabei wird, um diesen Nachteil zu vermeiden, der Eingangsstrom bei großen Eingangsspannungen oberhalb der Umschaltspannungsgrenze auf den Eingangsstrom gemäß der Typ 1-Charakteristik abgesenkt.

In einer Ausgestaltung der Erfindung sind einfache schaltungstechnische Maßnahmen vorgesehen, mittels welcher der Konstantstrom auf den ersten oder zweiten Wert eingestellt wird.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: eine Eingangskennlinie und
- Figur 2: eine mit einem Geber beschaltete Eingangsbeschaltung einer Digitaleingabeeinheit.

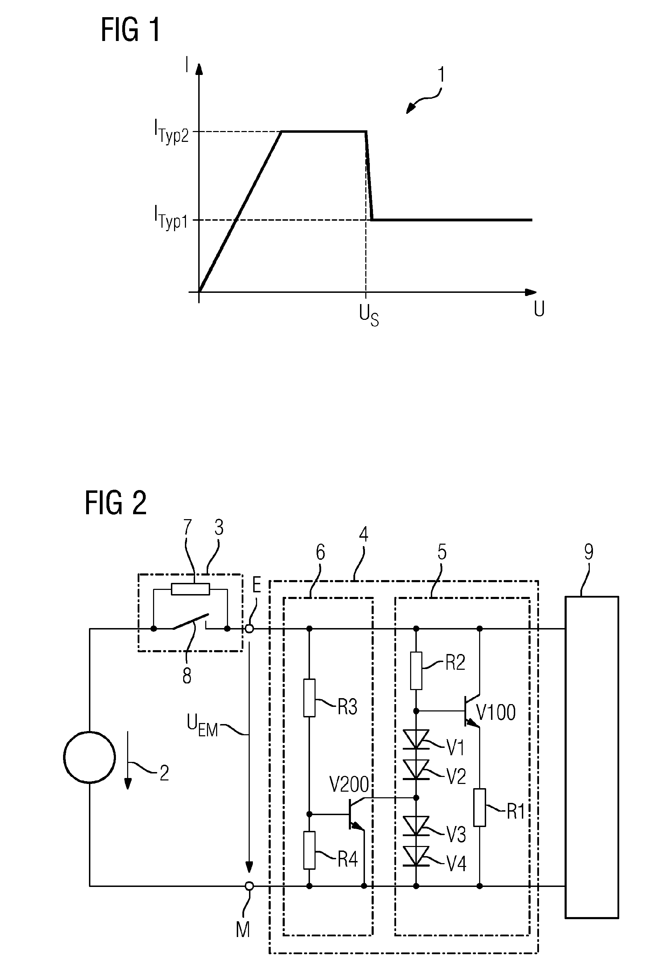

In Figur 1 ist mit 1 eine Eingangskennlinie einer Digitaleingabeeinheit bezeichnet, wobei die Eingangskennlinie die Abhängigkeit eines Eingangsstroms I von einer Eingangsspannung U repräsentiert und die Digitaleingabeeinheit z. B. für einen "Weitbereichseingang" mit einem DC-Nennspannungsbereich von 24 V bis 125 V vorgesehen ist. Bis zu einer Eingangsspannungsgrenze von 30V, welche die Obergrenze des 24V-Nennbereiches darstellt, weist die Digitaleingabeeinheit ein Typ 2-Verhalten gemäß der Norm IEC 61131 bzw. EN 61131 auf. Für einen Strom ziehenden Eingang einer derartigen Digitaleingabeeinheit repräsentiert die Eingangsspannung U in einem Bereich von -3 V bis 5 V und der Eingangsstrom I in einem Bereich von ND (Not Defined) bis 30 mA einen 0-Zustand und die Eingangsspannung U in einem Bereich von 11 V bis 30 V und der Eingangsstrom I in einem Bereich von 6 mA bis 30 mA einen 1-Zustand. Ein Eingangsspannungsbereich von 5 V bis 11 V definiert den so genannten Übergangsbereich, welcher weder einen 0- noch einen 1-Zustand beschreibt, wobei der Eingangskanal in diesem Übergangsbereich einen Strom von 2 mA bis 30 mA ziehen kann.

Der Eingangskanal weist bei niedrigen Eingangsspannungen U bis zu einer Spannung Uₛ ein ohmsches Verhalten auf und ist ferner dazu ausgebildet, unterhalb Uₛ den Eingangsstrom I auf einen ersten Wert I_{Typ2} zu begrenzen, wobei die Umschaltspannung Uₛ gleich oder größer der Spannungsgrenze von 30 V ist, bis zu welcher der 1-Signalzustand repräsentiert wird. Dieser erste Wert I_{Typ2} beträgt 6 mA bis 30 mA, welcher während des 1-Zustandes vom Eingangskanal gezogen wird.

Der Eingangskanal ist darüber hinaus dazu ausgebildet, ab dieser Umschaltspannung Uₛ den Eingangsstrom I auf einen im Vergleich zum ersten Wert I_{Typ2} geringeren zweiten Wert I_{Typ1} zu begrenzen. Dieser zweite Wert I_{Typ1} ist so gewählt, dass bei der den 1-Zustand repräsentierenden Eingangsspannung gemäß der Typ 1-Kennlinie dieser Wert im Bereich von 2 mA bis 15 mA liegt.

Im Folgenden wird auf Figur 2 verwiesen, in welcher ein mit einer Nennspannung 2 beaufschlagter Geber bzw. Nährungsschalter 3 und eine Eingangsbeschaltung 4 einer Digitaleingabeeinheit dargestellt sind.

Die Eingangsbeschaltung 4 umfasst eine Stromsenke 5 und Schaltmittel 6, welche in Abhängigkeit der Eingangsspannung an Klemmen E, M der Eingangsbeschaltung 4 die Stromsenke 5 in eine erste und eine zweite Betriebsart schalten.

Es wird angenommen, dass der Nährungsschalter 3 zur Positionserkennung eines Werkstückes vorgesehen ist und in Abhängigkeit der Position des Werkstückes seinen Widerstand ändert, was in der Zeichnung mittels eines Widerstandes 7 und eines Schalters 8 angedeutet ist. Diese Widerstandsänderung beeinflusst eine Eingangsspannung U_{EM} an Klemmen E, M der Eingangsbeschaltung 4, mittels welcher eine Schwellenauswertung 9 zur Bestimmung eines 0- oder 1-Signalzustandes beaufschlagt wird. In der ersten Betriebsart, in der die Eingangsspannung U_{EM} unterhalb der Umschaltspannung Uₛ (Figur 1) liegt, die sich aufgrund eines von Widerständen R3, R4 gebildeten Widerstandsverhältnisses ergibt, sperrt ein Transistor V200. In diesem Fall bestimmen Dioden V1, V2, V3, V4 zusammen mit einem Widerstand R1 den ersten Wert I_{Typ2} des Stromes I.

In einer zweiten Betriebsart, in der die Eingangsspannung U_{EM} die durch die Widerstände R3, R4 gebildete Umschaltspannung Uₛ überschreitet, schaltet der Transistor V200 durch und der Strom I wird durch die Dioden V1, V2 und den Widerstand R1 bestimmt. In diesem Fall stellt sich der Strom I auf den im Vergleich zum ersten Wert I_{Typ2} geringeren zweiten Wert I_{Typ1} ein.

Im Rahmen der vorliegenden Betrachtung kann die Diode V1 vernachlässigt werden, weil sich der Spannungsabfall und der Spannungsabfall an der Basis-Emitter-Diode eines Transistors V100 kompensieren, welcher mit dem Widerstand R1 in Serie geschaltet ist.

Die Erfindung lässt sich damit wie folgt zusammenfassen: Eine Digitaleingabeeinheit für ein Automatisierungsgerät mit mindestens einem Strom (I) ziehenden DC-Eingangskanal zum Anschluss eines an einer DC-Nennspannung betriebenen Gebers (3), wobei der Eingangskanal dazu ausgebildet ist, gemäß einer Eingangskennlinie den Strom (I) in Abhängigkeit der Eingangsspannung (U_{EM}) einzustellen, zeichnet sich dadurch aus, dass der Eingangskanal ferner dazu ausgebildet ist,
- bis zu einer Umschaltspannung Uₛ den Eingangsstrom (I) auf einen ersten Wert (I_{Typ2}) zu begrenzen, wobei die Umschaltspannung (Uₛ) gleich oder größer einer Spannungsgrenze ist, bis zu welcher ein 1-Signalzustand repräsentiert wird, und
- ab dieser Umschaltspannung (U_{S}) den Eingangsstrom (I) auf einen im Vergleich zum ersten Wert (I_{Typ2}) geringeren zweiten Wert (I_{Typ1}) zu begrenzen.

Eine derartige Digitaleinheit ist zum Anschluss von Gebern unterschiedlicher Versorgungsspannungen geeignet und kann mit einer verminderten Verlustleistung betrieben werden.

## Patentansprüche

1. Digitaleingabeeinheit für ein Automatisierungsgerät mit mindestens einem Strom (I) ziehenden DC-Eingangskanal zum Anschluss eines an einer DC-Nennspannung betriebenen Gebers (3), wobei der Eingangskanal dazu ausgebildet ist, gemäß einer Eingangskennlinie den Strom (I) in Abhängigkeit der Eingangsspannung (U_{EM}) einzustellen, **dadurch gekennzeichnet, dass** der Eingangskanal ferner dazu ausgebildet ist,
- bis zu einer Umschaltspannung Uₛ den Eingangsstrom (I) auf einen ersten Wert (I_{Typ2}) zu begrenzen, wobei die Umschaltspannung (Uₛ) gleich oder größer einer Spannungsgrenze ist, bis zu welcher ein 1-Signalzustand repräsentiert wird, und
- ab dieser Umschaltspannung (Uₛ) den Eingangsstrom (I) auf einen im Vergleich zum ersten Wert (I_{Typ2}) geringeren zweiten Wert (I_{Typ1}) zu begrenzen.

2. Digitaleingabeeinheit nach Anspruch 1, **dadurch gekennzeichnet, dass** der Eingangskanal aufweist:
- eine Stromsenke (R1, R2, V1 bis V4, V100) zur Erzeugung des Eingangsstroms (I) und
- Mittel (R3, R4, V200) zum Ansteuern der Stromsenke (R1, R2, V1 bis V4, V100), wobei die Mittel (R3, R4, V200) in Abhängigkeit der Umschaltspannung (Uₛ) die Stromsenke (R1, R2, V1 bis V4, V100) derart ansteuern, dass der Eingangsstrom (I) auf den ersten (I_{Typ2}) oder zweiten Wert (I_{Typ1}) begrenzt wird.
